(19) Europäisches Patentamt
European Patent Office
Office européen des brevets

(11) **EP 3 422 832 B1**

(12) **EUROPEAN PATENT SPECIFICATION**

(45) Date of publication and mention
of the grant of the patent:
**13.01.2021 Bulletin 2021/02**

(21) Application number: **17756395.4**

(22) Date of filing: **17.02.2017**

(51) Int Cl.:
*H05K 7/20* (2006.01)          *B32B 7/02* (2019.01)
*C01B 32/176* (2017.01)      *H01L 23/36* (2006.01)
*B32B 27/08* (2006.01)        *B32B 27/18* (2006.01)
*B32B 27/30* (2006.01)        *B32B 27/32* (2006.01)
*B32B 27/38* (2006.01)

(86) International application number:
**PCT/JP2017/006013**

(87) International publication number:
**WO 2017/145956 (31.08.2017 Gazette 2017/35)**

(54) **SECONDARY SHEET AND PRODUCTION METHOD FOR SECONDARY SHEET**

SEKUNDÄRE FOLIE UND HERSTELLUNGSVERFAHREN FÜR SEKUNDÄRE FOLIE

FEUILLE SECONDAIRE AINSI QUE PROCÉDÉ DE FABRICATION CE CELLE-CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.02.2016 JP 2016034833**

(43) Date of publication of application:
**02.01.2019 Bulletin 2019/01**

(73) Proprietor: **Zeon Corporation
Tokyo 100-8246 (JP)**

(72) Inventors:
• **ITO Toyokazu
Tokyo 100-8246 (JP)**
• **ITO Keisuke
Tokyo 100-8246 (JP)**

(74) Representative: **Maiwald Patent- und
Rechtsanwaltsgesellschaft mbH
Elisenhof
Elisenstraße 3
80335 München (DE)**

(56) References cited:
**EP-A1- 3 258 489          EP-A1- 3 343 605
JP-A- 2010 114 421      JP-A- 2010 132 856
JP-A- 2011 162 642      JP-A- 2013 103 375
JP-A- 2015 095 608**

**Description**

TECHNICAL FIELD

The present disclosure relates to a secondary sheet and a method of producing the same.

BACKGROUND

In recent years, electronic parts such as plasma display panels (PDPs) and integrated circuit (IC) chips generate more heat along with their increasing performance. This has led to the necessity of taking measures to prevent function failure due to temperature rises in the electronic parts of electronic devices.

General measures to prevent function failure due to temperature rise in an electronic part involve attaching a heat radiator such as a metallic heat sink, a radiation plate or a radiation fin to a heat source such as an electronic part to facilitate heat dissipation. When a heat radiator is used, the heat radiator and the heat source are closely attached to each other via a sheet member having high heat conductivity (heat conductive sheet) under a certain pressure in order to efficiently transfer heat from the heat source to the heat radiator. As the heat conductive sheet, a sheet molded using a composite material sheet having excellent heat conductivity is used. Hence, heat conductive sheets sandwiched between a heat source and a heat radiator during use are required to have high flexibility, as well as high heat conductivity.

Generally, a heat conductive sheet is produced from a composition containing a resin material with high flexibility and a carbon material with high heat conductivity. For the purpose of enhancing the heat conductivity of the heat conductive sheet, methods have been examined for producing a heat conductive sheet that contains an anisotropically shaped carbon material as the carbon material aligned in the thickness direction of the sheet.

For example, in JPWO2008053843A (PTL 1), primary sheet (pre-heat conductive sheet) in which graphite particles are aligned parallel to the planar direction are prepared by rolling a composition containing an organic polymer compound having a specific glass transition temperature and graphite particles having a predetermined shape and a crystal structure in which a 6-membered ring is aligned in a predetermined direction, the primary sheets are stacked on top of each other to provide a laminate, and the laminate is sliced vertically to the stacking direction to provide a secondary sheet (heat conductive sheet) in which graphite particles are aligned in the thickness direction of the sheet.

Factors that affect the thermal resistance of a heat conductive sheet are the heat conductivity of the heat conductive sheet itself, the interfacial thermal resistance with respect to the heat source and the heat radiator (e.g., a heat sink), and the thickness of the heat conductive sheet, it has been conventionally difficult to slice the laminate evenly and thinly to provide a secondary sheet. There are various methods of slicing the laminate. From the viewpoint of slicing and profile irregularity, among others, plane slicing is excellent. However, plane slicing has a problem in that the secondary sheet obtained by slicing curls. To address this issue, methods have been studied for slicing the laminate.

For example, JP2011218504A (PTL 2) describes a method of obtaining a secondary sheet having a uniform thickness by slicing a laminate formed by stacking resin sheets with a single-blade plane instead of a double-blade plane (a plane with a pair of blades). In this method, when a double-blade plane is used, a secondary sheet obtained by slicing with one of a pair of blades (that is, two blades) is prevented from being damaged or curled by contact with the other blade.

For example, JP2013131562A (PTL 3) describes a method of producing a thermally conductive sheet, including: extruding a composition containing a curable resin and carbon fibers with an extruder to mold preformed molded products of elongated columnar shape in which carbon fibers are aligned along the extrusion direction; stacking the preformed molded products on top of each other in alignment to provide a laminate; curing the laminate to provide a final molded product; and slicing the final molded product using an ultrasonic cutter in a direction orthogonal to the longitudinal direction of the preformed molded products.
In this method, slicing is performed using an ultrasonic cutter to suppress disturbance in the alignment of carbon fibers, thereby improving the heat conductivity in the thickness direction of the heat conductive sheet.

CITATION LIST

Patent Literature

PTL 1:JPWO2008053843A
PTL 2:JP2011218504A
PTL 3:JP2013131562A

SUMMARY

(Technical Problem)

However, with any of the slicing methods described in PTLs 1 to 3, curling of the secondary sheet obtained by slicing the laminate of primary sheets can not be sufficiently suppressed.

That is, none of these methods provide a laminate that enables production of a secondary sheet that contains a particulate carbon material aligned in the thickness direction and in which curling is sufficiently suppressed, a method of producing the same, or a method of producing a secondary sheet that contains a particulate carbon material aligned in the thickness direction and in which curling is sufficiently suppressed.

It would thus be helpful to provide a secondary sheet that contains a particulate carbon material aligned in the thickness direction and in which curling is suppressed.

(Solution to Problem)

The inventors made extensive studies to achieve the foregoing objects. The present invention discloses a method of producing a secondary sheet according to the present disclosure comprising: shaping a composition containing a resin comprising a thermoplastic resin that is liquid at a temperature of 23 °C and a particulate carbon material having an average diameter of 300 $\mu$m or less and comprising expanded graphite with a content of the particulate carbon material being 50% by mass or less into a sheet by pressure application to provide a primary sheet having a tensile strength of 1.5 MPa or less, wherein the tensile strength is measured according to JIS K6251; obtaining a laminate comprising two or more layers formed either by stacking a plurality of the primary sheets on top of each other or by folding or rolling the primary sheet; and slicing the laminate at an angle of 45° or less relative to the stacking direction to provide a secondary sheet. By slicing the laminate at an angle of 45° or less relative to the stacking direction, it is possible to produce a secondary sheet that contains a particulate carbon material aligned in the thickness direction and in which curling is suppressed.

In the method of producing a secondary sheet according to the present disclosure the secondary sheet has a curl index of 0.33 or less, where the curl index is obtained by, when the secondary sheet is formed into a square of 50 mm × 50 mm, a 65 g weight of 55 mm × 55 mm is placed on a flat surface thereof for 10 seconds, and the weight is then removed, dividing a curl height by 50 mm, which is the length of one side of the secondary sheet, where the curl height is measured in millimeters from the flat surface in a direction perpendicular to the flat surface. When the curl index is 0.33 or less, it is possible to produce a secondary sheet in which curling is sufficiently suppressed.

The present disclosure provides a secondary sheet comprising a resin and a particulate carbon material with a content of the particulate carbon material being 50% by mass or less such that the particulate carbon material is aligned in the thickness direction, wherein the secondary sheet has a curl index of 0.33 or less, where the curl index is obtained by, when the secondary sheet is formed into a square of 50 mm × 50 mm, a 65 g weight of 55 mm × 55 mm is placed on a flat surface thereof for 10 seconds, and the weight is then removed, dividing a curl height by 50 mm, which is the length of one side of the secondary sheet, where the curl height is measured in millimeters from the flat surface in a direction perpendicular to the flat surface, the resin comprises a thermoplastic resin that is liquid at a temperature of 23 °C and the particulate carbon material has an average diameter of 300 $\mu$m or less and comprises expanded graphite. When the curl index is 0.33 or less, it is possible to sufficiently suppress curling of the secondary sheet, provide excellent handleability during use, and improve the performance of products made of or including the secondary sheet.

(Advantageous Effect)

According to the present disclosure, it is possible to provide a method of producing a secondary sheet that contains a particulate carbon material aligned in the thickness direction and in which curling is suppressed, and such secondary sheet.

BRIEF DESCRIPTION OF THE DRAWINGS

In the accompanying drawings:

FIG. 1 is a conceptual diagram illustrating a cross section of a blade edge of one of the embodiments of a blade usable in slicing of the laminate disclosed herein;
FIG. 2 is a conceptual diagram illustrating a cross section of a blade edge of a double-edged symmetrical blade, which is one of the embodiments of a blade usable in slicing of the laminate disclosed herein;
FIG. 3 is a conceptual diagram illustrating a cross section of a blade edge of a double-edged asymmetrical blade, which is one of the embodiments of a blade usable in slicing of the laminate disclosed herein;

FIG. 4 is a conceptual diagram illustrating a cross section of a blade edge of a single-edged blade, which is one of the embodiments of a blade usable in slicing of the laminate disclosed herein;

FIG. 5A is a conceptual diagram of one of the embodiments of a blade usable in slicing of the laminate disclosed herein as viewed generally from the side, and FIG. 5B is a conceptual diagram of the blade as viewed generally from the front;

FIGS. 6A and 6B are conceptual diagrams for explaining how a central axis is defined in the case of a single-edged blade, which is one of the embodiments of a blade usable in slicing of the laminate disclosed herein.

FIGS. 7A and 7B are conceptual diagrams for explaining how a central axis is defined in the case of a double-edged blade, which is one of the embodiments of a blade usable in slicing of the laminate disclosed herein;

FIG. 8 is a conceptual diagram illustrating a cross section of a blade edge of a double-step blade, which is one of the embodiments of a blade usable in slicing of the laminate disclosed herein; and

FIGS. 9A and 9B are each a conceptual diagram of one of the embodiments of a double-blade configuration usable in slicing of the laminate disclosed herein as viewed generally from the side.

DETAILED DESCRIPTION

Embodiments of the present disclosure will now be described in detail.

(Laminate)

The laminate disclosed herein comprises two or more layers formed from at least one primary sheet, the at least one primary sheets containing a resin and a particulate carbon material with a content of the particulate carbon material being 50% by mass or less, and the at least one primary sheets having a tensile strength of 1.5 MPa or less. The laminate can be used for the production of a secondary sheet. The laminate can be produced, for example, by using the method according to the disclosure.

(Primary Sheet)

It is preferable that the at least one primary sheet forming the disclosed laminate contains a resin and a particulate carbon material with a content of the particulate carbon material being 50% by mass or less, and has a tensile strength of 1.5 MPa or less. When the at least one primary sheet does not contain the particulate carbon material, sufficient heat conductivity can not be obtained. Also, when the at least one primary sheet contains no resin, sufficient flexibility can not be obtained.

- Resin -

As used herein, the resin is not particularly limited, and any known resin usable for forming a laminate can be used. Of these, preferred is a thermoplastic resin. When a thermoplastic resin is used, the dispersibility of the particulate carbon material and the formability of the at least one primary sheet can be improved, and two or more layers formed from the at least one primary sheet can be bonded to each other by thermal pressure bonding without using an adhesive or a solvent. Further, a thermosetting resin can be used in combination without impairing the properties and effects of the at least one primary sheet and the laminate.

As used herein, "resin" encompasses rubbers and elastomers.

- Thermoplastic Resins -

Examples of known thermoplastic resins that can be contained in the at least one primary sheet include a thermoplastic resin that is solid at ordinary temperature and a thermoplastic resin that is liquid at ordinary temperature. As used herein, the thermoplastic resin contained in the at least one primary sheet is not particularly limited, yet it is preferable to use a thermoplastic resin that is liquid at ordinary temperature. As used herein, "ordinary temperature" means 23 °C. When a thermoplastic resin that is liquid at ordinary temperature is used as the thermoplastic resin, it is possible to further reduce the internal stress of the laminate and thus suppress curling of the secondary sheet. Further, even at a relatively low pressure (e.g., 0.1 MPa or less), the interfacial thermal resistance can be lowered by increasing the interfacial adhesion, and the heat conductivity (i.e., heat dissipation characteristics) of the secondary sheet can be improved.

Examples of the thermoplastic resin that is liquid at ordinary temperature include acrylic resins, epoxy resins, silicone resins, and fluororesins. These thermoplastic resins may be used alone or in combination.

Further, a thermoplastic resin that is solid at ordinary temperature can be used in combination without impairing the properties and effects of the at least one primary sheet and the laminate. Examples of thermoplastic resins that are solid at ordinary temperature include: acrylic resins such as poly(2-ethylhexyl acrylate), copolymers of acrylic acid and 2-ethylhexyl acrylate, polymethacrylic acids or esters thereof, and polyacrylic acids or esters thereof; silicone resins; fluororesins; polyethylenes; polypropylenes; ethylene-propylene copolymers; polymethylpentenes; polyvinyl chlorides; polyvinylidene chlorides; polyvinyl acetates; ethylene-vinyl acetate copolymers; polyvinyl alcohols; polyacetals; polyethylene terephthalates; polybutylene terephthalates; polyethylene naphthalates; polystyrenes; polyacrylonitriles; styrene-acrylonitrile copolymers; acrylonitrile-butadiene-styrene copolymers (ABS resins); styrene-butadiene block copolymers or hydrogenated products thereof; styrene-isoprene block copolymers or hydrogenated products thereof; polyphenylene ethers; modified polyphenylene ethers; aliphatic polyamides; aromatic polyamides; polyamideimides; polycarbonates; polyphenylene sulfides; polysulfones; polyether sulfones; polyether nitriles; polyether ketones; polyketones; polyurethanes; liquid crystal polymers; and ionomers. These thermoplastic resins may be used alone or in combination.

-- Thermoplastic Fluororesins --

The thermoplastic resin contained in the at least one primary sheet of the present disclosure preferably contains, and more preferably consists of, a thermoplastic fluororesin. By using a thermoplastic fluororesin as the thermoplastic resin, heat resistance, oil resistance, and chemical resistance of the laminate and the secondary sheet can be improved. More preferably, the thermoplastic resin contained in the at least one primary sheet of the present disclosure is a thermoplastic fluororesin that is liquid at ordinary temperature. By using a thermoplastic fluororesin that is liquid at ordinary temperature as the thermoplastic resin, in addition to improving the heat resistance, oil resistance, and chemical resistance of the laminate and the secondary sheet, it is also possible to further reduce the internal stress of the laminate and thus suppress curling of the secondary sheet. Further, even at a relatively low pressure, the interfacial thermal resistance can be lowered by increasing the interfacial adhesion, and the heat conductivity (i.e., heat dissipation characteristics) of the secondary sheet can be improved.

The thermoplastic fluororesin that is liquid at ordinary temperature is not particularly limited as long as it is a fluororesin that is in liquid form at ordinary temperature (23 °C). Examples thereof include vinylidene fluoride/hexafluoropropylene copolymers, vinylidene fluoride-hexafluoropentene-tetrafluoroethylene terpolymers, perfluoropropene oxide polymers, and tetrafluoroethylene-propylene-vinylidene fluoride copolymers. The thermoplastic fluororesin that is liquid at ordinary temperature may be a commercially available product, including, for example, Viton® LM (produced by Du Pont; Viton is a registered trademark in Japan, other countries, or both), Daiel® G101 (produced by Daikin Industries, Ltd.; Daiel is a registered trademark in Japan, other countries, or both), Dyneon FC 2210 (produced by 3M Company), and SIFEL series (produced by Shin-Etsu Chemicals, Co., Ltd.).

The viscosity of the thermoplastic fluororesin that is liquid at ordinary temperature is not particularly limited, yet from the viewpoint of good kneadability, flowability, and crosslinking reactivity, and excellent formability, the viscosity at 105 °C is preferably from 500 cps to 30,000 cps, and more preferably from 550 cps to 25,000 cps.

Further, a thermoplastic fluororesin that is solid at ordinary temperature can be used in combination without impairing the properties and effects of the at least one primary sheet and the laminate. Examples of the thermoplastic fluororesin that is solid at ordinary temperature include elastomers obtained by polymerizing fluorine-containing monomers, such as vinylidene fluoride-based, tetrafluoroethylene-propylene-based, and tetrafluoroethylene-perfluorovinyl ether-based ones. More specific examples include polytetrafluoroethylene, tetrafluoroethylene-perfluoroalkyl vinyl ether copolymers, tetrafluoroethylene-hexafluoropropylene copolymers, tetrafluoroethylene-ethylene copolymers, polyvinylidene fluoride, polychlorotrifluoroethylene, ethylene-chlorofluoroethylene copolymers, tetrafluoroethylene-perfluorodioxole copolymers, polyvinyl fluoride, tetrafluoroethylene-propylene copolymers, vinylidene fluoride-tetrafluoroethylene-hexafluoropropylene copolymers, acrylic modified products of polytetrafluoroethylene, ester modified products of polytetrafluoroethylene, epoxy modified products of polytetrafluoroethylene, and silane-modified products of polytetrafluoroethylene. Of these, from the viewpoint of processability, it is preferable to use polytetrafluoroethylene, acrylic modified products of polytetrafluoroethylene, tetrafluoroethylene-perfluoroalkyl vinyl ether copolymers, vinylidene fluoride-tetrafluoroethylene-hexafluoropropylene copolymers.

- Thermosetting Resins -

Without impairing the properties and effects of the at least one primary sheet and the laminate disclosed herein, examples of optional thermosetting resins include: natural rubbers; butadiene rubbers, isoprene rubbers, nitrile rubbers, hydrogenated nitrile rubbers; chloroprene rubbers; ethylene propylene rubbers; chlorinated polyethylenes; chlorosulfonated polyethylenes; butyl rubbers; halogenated butyl rubbers; polyisobutylene rubbers; epoxy resins; polyimide resins; bismaleimide resins; benzocyclobutene resins; phenol resins; unsaturated polyesters; diallyl phthalate resins; polyimide silicone resins; polyurethanes; thermosetting polyphenylene ethers; and thermosetting modified polyphenylene ethers.

These thermosetting resins may be used alone or in combination.

- Particulate Carbon Material -

Examples of usable particulate carbon materials include, but are not limited to, graphite such as artificial graphite, flake graphite, flaked graphite, natural graphite, acid-treated graphite, expandable graphite, and expanded graphite; and carbon black. These particulate carbon materials may be used alone or in combination.

Of these, preferred is expanded graphite. The reason is that expanded graphite is easily aligned in the planar direction of the at least one primary sheet, and the heat conductivity of the secondary sheet can be improved.

-- Expanded Graphite --

Expanded graphite which may be suitably used as the particulate carbon material can be obtained for example by thermal expansion of expandable graphite which has been obtained by chemical treatment of graphite such as flake graphite with sulfuric acid followed by micronization. Examples of expanded graphite include products available from Ito Graphite Co., Ltd. under the trade names EC1500, EC1000, EC500, EC300, EC100, and EC50.

-- Properties of Particulate Carbon Material --

The particulate carbon material contained in the at least one primary sheet of the present disclosure has an average particle diameter of preferably 0.1 $\mu$m or more, more preferably 1 $\mu$m or more, further preferably 10 $\mu$m or more, and even more preferably 50 $\mu$m or more. Also, the particulate carbon material has an average particle diameter of preferably 300 $\mu$m or less, more preferably 250 $\mu$m or less, and further preferably 200 $\mu$m or less. When the average particle diameter of the particulate carbon material is within the above range, it is possible to improve the balance between the hardness and tackiness of the secondary sheet to provide better handleability, while lowering the thermal resistance of the secondary sheet to improve the heat conductivity.

The aspect ratio (major axis/minor axis) of the particulate carbon material contained in the at least one primary sheet of the present disclosure is preferably 1 or more and 10 or less, and more preferably 1 or more and 5 or less.

The "average particle diameter" herein can be found by measuring maximum diameters (major diameters) for 50 randomly-selected particulate carbon materials observed in a thickness-direction cross-sectional scanning electron micrograph (SEM) of the secondary sheet, and calculating the number-average of the measured major axis lengths. The "aspect ratio" herein can be found by measuring maximum diameters (major diameters) and diameters in a direction perpendicular to the maximum diameters (minor diameters) for randomly-selected 50 particulate carbon materials observed in a thickness-direction cross-sectional scanning electron micrograph (SEM) of the secondary sheet, and calculating the average of ratios of the major diameter to the minor diameter (major diameter/minor diameter).

-- Particulate Carbon Material Content --

The at least one primary sheet disclosed herein preferably contains the particulate carbon material in an amount of 50% by mass or less, preferably 45% by mass or less, more preferably 40% by mass or less, and even more preferably 35% by mass or less, but preferably 5% by mass or more, and more preferably 10% by mass or more. When the content of the particulate carbon material in the at least one primary sheet is 50% by mass or less, it is possible to sufficiently reduce the internal stress of the laminate while setting the tensile strength of the at least one primary sheet to a predetermined range, and to sufficiently suppress curling of the secondary sheet obtained by slicing the laminate at an angle of 45° or less relative to the stacking direction. When the content of the particulate carbon material in the at least one primary sheet is 5% by mass or more, the secondary sheet will have sufficient heat conductivity.

- Fibrous Carbon Material -

The at least one primary sheet may optionally contain a fibrous carbon material. Examples of optionally usable fibrous carbon materials include carbon nanotubes, vapor grown carbon fibers, carbon fibers obtained by carbonization of organic fibers, and chopped products thereof. These fibrous carbon materials may be used alone or in combination.

When the fibrous carbon material is contained in the at least one primary sheet, the secondary sheet will have improved heat conductivity and dusting of the particulate carbon material can be prevented. A possible, but still uncertain reason that blending of the fibrous carbon material prevents dusting of the particulate carbon material would be that the fibrous carbon material forms a three-dimensional structure whereby separation of the particulate carbon material is prevented while increasing heat conductivity and strength.

Of these fibrous carbon materials described above, preferred are fibrous carbon nanostructures such as carbon nanotubes, with fibrous carbon nanostructures including carbon nanotubes being more preferred. The use of fibrous carbon nanostructures such as carbon nanotubes allows for further increases in the heat conductivity and strength of the disclosed secondary sheet.

-- Fibrous Carbon Nanostructures including Carbon Nanotubes --

The fibrous carbon nanostructures including carbon nanotubes, which may be suitably used as the fibrous carbon material, may be composed solely of carbon nanotubes (hereinafter occasionally referred to as "CNTs") or may be a mixture of CNTs and fibrous carbon nanostructures other than CNTs.

Any type of CNTs may be used for the fibrous carbon nanostructures, such as, for example, single-walled carbon nanotubes and/or multi-walled carbon nanotubes, with single- to up to 5-walled carbon nanotubes being preferred, and single-walled carbon nanotubes being more preferred. The use of single-walled carbon nanotubes will further improve, as compared to the use of multi-walled carbon nanotubes, the heat conductivity and strength of the secondary sheet.

In addition, the fibrous carbon nanostructures including CNTs are carbon nanostructures for which a ratio ($3\sigma$/Av) of a value obtained by multiplying the standard deviation ($\sigma$) of the diameters by three ($3\sigma$) to the average diameter (Av) is preferably greater than 0.20 and less than 0.60, more preferably greater than 0.25, and further preferably greater than 0.50. By using fibrous carbon nanostructures including CNTs for which $3\sigma$/Av is greater than 0.20 and less than 0.60, the heat conductivity and strength of the secondary sheet can be increased sufficiently even if the blending amount of carbon nanostructures is small. Accordingly, blending the fibrous carbon nanostructures including CNTs may suppress increase in the hardness (i.e., decrease in the flexibility) of the secondary sheet, making it possible to maintain both the heat conductivity and flexibility of the disclosed secondary sheet at a sufficiently high level. As used herein, the "average diameter of fibrous carbon nanostructures (Av)" and the "standard deviation of diameters of fibrous carbon nanostructures ($\sigma$: sample standard deviation)" can each be obtained by measuring the diameters (external diameters) of 100 randomly selected carbon nanostructures using a transmission electron microscope. The standard deviation ($\sigma$) may be adjusted by changing the production method and the production conditions of fibrous carbon nanostructures including CNTs, or may be adjusted by combining different types of fibrous carbon nanostructures including CNTs obtained by different production methods.

The carbon nanostructures including CNTs that are used typically take a normal distribution when a plot is made of diameter measured as described above on a horizontal axis and frequency on a vertical axis, and a Gaussian approximation is made.

Furthermore, the fibrous carbon nanostructures including CNTs preferably exhibit a radial breathing mode (RBM) peak when evaluated by Raman spectroscopy. Raman spectra of fibrous carbon nanostructures composed solely of three or more multi-walled carbon nanotubes have no RBM.

Moreover, in a Raman spectrum of the fibrous carbon nanostructures including CNTs, a ratio (G/D ratio) of G band peak intensity relative to D band peak intensity is preferably at least 1 and no greater than 20. If the G/D ratio is at least 1 and no greater than 20, the heat conductivity and strength of the secondary sheet can be increased sufficiently even if the blending amount of fibrous carbon nanostructures is small. It is thus possible to suppress increase in the hardness (i.e., decrease in the flexibility) of the secondary sheet due to the blending of the fibrous carbon nanostructures, and to maintain both the heat conductivity and flexibility of the disclosed secondary sheet at a sufficiently high level.

The average diameter (Av) of the fibrous carbon nanostructures including CNTs is preferably at least 0.5 nm, and more preferably at least 1 nm, and is preferably no greater than 15 nm, and more preferably no greater than 10 nm. When the average diameter (Av) of the fibrous carbon nanostructures is at least 0.5 nm, aggregation of the fibrous carbon nanostructures can be suppressed to increase the dispersibility of the carbon nanostructures. Further, when the average diameter (Av) of the fibrous carbon nanostructures is no greater than 15 nm, the heat conductivity and strength of the secondary sheet can be sufficiently increased.

The average length of the fibrous carbon nanostructures including CNTs at the time of synthesis is preferably at least 100 $\mu$m and no greater than 5,000 $\mu$m. CNTs that have a longer structure length at the time of synthesis tend to be more easily damaged by breaking, or severing during dispersing. Therefore, it is preferable that the average length of the structure at the time of synthesis is no greater than 5,000 $\mu$m.

Moreover, the fibrous carbon nanostructures including CNTs preferably have a BET specific surface area of 600 $m^2$/g or more, and more preferably 800 $m^2$/g or more, but preferably 2,500 $m^2$/g or less, and more preferably 1,200 $m^2$/g or less. Furthermore, the BET specific surface area is preferably at least 1,300 $m^2$/g in a situation in which the CNTs in the fibrous carbon nanostructures are mainly open CNTs. When the BET specific surface area of the fibrous carbon nanostructures including CNTs is at least 600 $m^2$/g, the heat conductivity and strength of the disclosed secondary sheet can be sufficiently increased. When the BET specific surface area of the carbon nanostructures including CNTs is no greater than 2,500 $m^2$/g, aggregation of the fibrous carbon nanostructures can be suppressed to increase the dispersibility of the CNTs in the secondary sheet.

As used herein, "BET specific surface area" refers to a nitrogen adsorption specific surface area measured by the BET method.

According to a super growth method described below, the fibrous carbon nanostructures including CNTs are obtained as an aggregate that is aligned in a perpendicular direction (aligned aggregate) on a substrate having a catalyst layer for carbon nanotube growth on the surface thereof. The mass density of the fibrous carbon nanostructures in the form of the aforementioned aggregate is preferably at least 0.002 g/cm$^3$ and no greater than 0.2 g/cm$^3$. When the mass density is 0.2 g/cm$^3$ or less, the binding between fibrous carbon nanostructures becomes weak such that the fibrous carbon nanostructures can be homogeneously dispersed in the secondary sheet. Moreover, a mass density of at least 0.002 g/cm$^3$ makes the fibrous carbon nanostructures easier to handle by improving the unity of the fibrous carbon nanostructures and preventing them from becoming unbound.

Fibrous carbon nanostructures including CNTs having the properties described above can, for example, be produced efficiently in accordance with a method (super growth method; refer to WO2006011655A1) in which, in synthesis of CNTs through chemical vapor deposition (CVD) by supplying a feedstock compound and a carrier gas onto a substrate having a catalyst layer for carbon nanotube production on the surface thereof, catalytic activity of the catalyst layer is dramatically improved by providing a trace amount of an oxidant (catalyst activating material) in the system. Hereinafter, carbon nanotubes obtained by the super growth method may also be referred to as "SGCNTs."

The fibrous carbon nanostructures including CNTs produced by the super growth method may be composed solely of SGCNTs or may include, in addition to SGCNTs, other carbon nanostructures such as non-cylindrical carbon nanostructures.

-- Properties of Fibrous Carbon Material --

The fibrous carbon material which may be included in the at least one primary sheet preferably has an average fiber diameter of 1 nm or more, preferably 3 nm or more, but preferably 2 $\mu$m or less, more preferably 1 $\mu$m or less. When the average fiber diameter of the fibrous carbon material falls within this range, it is possible to maintain the heat conductivity, flexibility, and strength of the disclosed heat conductive sheet simultaneously at a sufficiently high level. The aspect ratio of the fibrous carbon material preferably exceeds 10.

The "average fiber diameter" herein can be found by measuring fiber diameters for 50 randomly-selected fibrous carbon materials observed in a vertical (thickness direction) cross-sectional scanning electron micrograph (SEM) or transmission electron micrograph (TEM) of the secondary sheet, and calculating the number-average of the measured fiber diameters. In particular, for smaller fiber diameters, it is suitable to observe a similar cross section with a transmission electron microscope (TEM).

-- Fibrous Carbon Material Content --

The at least one primary sheet preferably contains the fibrous carbon material in an amount of 0.05% by mass or more, and more preferably 0.2% by mass or more, but preferably 5% by mass or less, and more preferably 3% by mass or less. When the at least one primary sheet contains the fibrous carbon material in an amount of 0.05% by mass or more, it is possible to sufficiently increase the heat conductivity and strength of the secondary sheet, as well as to sufficiently prevent dusting of the particulate carbon material. Further, when the content of the fibrous carbon material in the at least one primary sheet is 5% by mass or less, it is possible to suppress increase in the hardness (i.e., decrease in the flexibility) of the secondary sheet due to the blending of the fibrous carbon material, and to maintain both the heat conductivity and flexibility of the disclosed secondary sheet at a sufficiently high level.

- Additives -

Optionally, known additives that can be used for forming the at least one primary sheet can be blended in the at least one primary sheet. Any additive may be blended into the at least one primary sheet. Examples of additives include plasticizers such as fatty acid esters; flame retardants such as red phosphorus flame retardants and phosphate flame retardants; toughness improvers such as urethane acrylates; moisture absorbents such as calcium oxide and magnesium oxide; adhesion improvers such as silane coupling agents, titanium coupling agents, and acid anhydrides; wettability improvers such as nonionic surfactants and fluorine surfactants; and ion trapping agents such as inorganic ion exchangers.

- Tensile Strength of Primary Sheet -

The tensile strength of the at least one primary sheet forming the disclosed laminate is 1.5 MPa or less, preferably 1.0 MPa or less, and more preferably 0.7 MPa or less, and is preferably 0.3 MPa or more, and more preferably 0.4 MPa or more. When the tensile strength of the at least one primary sheet is 1.5 MPa or less, it is possible to sufficiently reduce the internal stress of the laminate while setting the content of the particulate carbon material in the at least one primary sheet to 50% by mass or less, and to sufficiently suppress curling of the secondary sheet obtained by slicing the laminate at an angle of 45° or less relative to the stacking direction. When the tensile strength of the at least one primary sheet is 0.3 MPa or more, it is possible to impart strength sufficient for handling the primary sheet itself and the laminate.

The tensile strength of the at least one primary sheet can be measured according to JIS K6251 and can be measured using, e.g., a tensile tester (e.g., "AG-IS 20 kN", trade name, produced by Shimadzu Corporation).

- Properties of Secondary Sheet -

The secondary sheet produced using the laminate disclosed herein is not particularly limited, and preferably has the following properties.

-- Curling of Secondary Sheet --

The degree of curling of the secondary sheet of the present disclosure can be evaluated using the curl index determined by the following curling test. The curl index is obtained by, when the secondary sheet obtained by slicing the laminate at an angle of 45° or less relative to the stacking direction is made into a square (50 mm × 50 mm), a weight (55 mm × 55 mm, 65 g) is placed on a flat surface thereof for 10 seconds, and the weight is then removed, dividing a curl height by the length (50 mm) of one side of the secondary sheet, where the curl height is measured in millimeters from the flat surface in a direction perpendicular to the flat surface. As used herein, the numerical value indicating the degree of curling is referred to as the "curl index". The curl index is expressed as a numerical value larger than 0 and smaller than 1. The curl height can be measured using, e.g., a digital caliper (e.g., "ABS Inside Digimatic Caliper", trade name, produced by Mitutoyo Corporation).

The curl index of the secondary sheet is preferably 0.33 or less, more preferably 0.25 or less, and still more preferably 0.15 or less. When the curl index of the secondary sheet is 0.33 or less, the curling of the secondary sheet can be considered as being sufficiently suppressed.

When the curling of the secondary sheet is sufficiently suppressed, it is possible to provide excellent handleability during use and improve the performance of products made of or including the secondary sheet.

-- Thermal Resistance of Secondary Sheet --

The secondary sheet has a thermal resistance under a pressure of 0.05 MPa of preferably 0.20 °C/W or less. When the thermal resistance under a pressure of 0.05 MPa is 0.20 °C/W or less, it is possible to provide excellent heat conductivity in the use environment under a relatively low pressure.

Here, the value of the thermal resistance can be measured with a known measurement method usually used for measuring the thermal resistance of the heat conductive sheet, e.g., using a resin material thermal resistance tester (e.g., "C47108", trade name, produced by Hitachi Technologies and Services, Ltd.).

In the secondary sheet, it is preferable that the change rate of the thermal resistance value when the applied pressure is changed from 0.50 MPa to 0.05 MPa is +150.0% or less. When the change rate of the thermal resistance value when the applied pressure is changed from 0.50 MPa to 0.05 MPa is +150.0% or less, the amount of increase in the thermal resistance value accompanying the decrease in the applied pressure is small, and the hardness can be maintained at a certain level. Therefore, the balance between hardness and tackiness can be improved, and the handleability can be improved.

The change rate of the thermal resistance value when the applied pressure is lowered from 0.5 MPa to 0.05 MPa can be calculated by:

$$100 \times ([\text{thermal resistance under the pressure of 0.05 MPa}] - [\text{thermal resistance under the pressure of 0.5 MPa}]) / \text{thermal resistance under the pressure of 0.5 MPa (\%).}$$

-- Tack of Secondary Sheet --

In the secondary sheet, the tack measured by the probe tack test is preferably 0.80 N or less. "Tack" means a property of adhering to an adherend in a short time with a light force as defined in JIS Z0109:2015, which is also referred to herein as "adhesiveness". The tack of the secondary sheet is measured by the probe tack test. Specifically, the tack is measured as the force required to pull away a flat probe of $\phi$ 10 mm from the secondary sheet to be measured after the probe is pressed against the secondary sheet for 10 seconds under the temperature condition of 25 °C while applying a pressure of 0.5 N. When the tack measured by the probe tack test is 0.80 N or less, it is possible to provide excellent close adherence during use while exhibiting good peelability at the time of attachment and replacement, and to remove the secondary sheet from the attachment such as a heat source or a heat radiator without impairing the secondary sheet, that is, without leaving secondary sheet components on the attachment.

The tack of the secondary sheet can be measured with, e.g., a probe tack testing machine (e.g., "TAC 1000", trade name, produced by RHESCA Co., Ltd.).

-- Hardness of Secondary Sheet --

The secondary sheet has an Asker C hardness at 25 °C of 60 or more, preferably 65 or more, and more preferably 70 or more. When the Asker C hardness at 25 °C is 60 or more, appropriate hardness can be provided at room temperature, and the workability at the time of attachment and replacement can be improved.

Also, the Asker C hardness at 25 °C of the secondary sheet is preferably 90 or less, and more preferably 80 or less. When the Asker C hardness at 25 °C is 90 or less, sufficient stickiness can be obtained in a room temperature environment, and the workability at the time of attachment and replacement can be further improved.

The "Asker C hardness" can be measured at a predetermined temperature using a hardness tester according to the Asker C method specified in the Japan Rubber Association Standard (SRIS).

-- Heat Conductivity of Secondary Sheet --

The heat conductivity in the thickness direction of the secondary sheet is, at 25 °C, preferably 20 W/m·K or more, more preferably 30 W/m·K or more, and further preferably 40 W/m·K or more. The heat conductivity of 20 W/m·k or more is high enough for the heat conductive sheet, when for example sandwiched between a heat source and a heat radiator, to efficiently transfer heat from the heat source to the heat radiator.

-- Thickness of Secondary Sheet --

The thickness of the secondary sheet is preferably 0.05 mm (50 $\mu$m) or more and 10 mm or less, and more preferably 0.2 mm (200 $\mu$m) or more and 5 mm or less. It is possible to reduce the bulk thermal resistance of the secondary sheet by reducing the thickness of the secondary sheet as long as the handleability is not impaired, and to improve the heat conductivity and the heat dissipation characteristics of the secondary sheet when used in a heat dissipation device.

-- Density of Secondary Sheet --

Further, the density of the secondary sheet is preferably 1.8 g/cm$^3$ or less, and more preferably 1.6 g/cm$^3$ or less. Such a secondary sheet has high versatility and can contribute to weight reduction of products such as electronic parts when mounted thereon.

<Method of Producing Laminate>

The method of producing a laminate according to the present disclosure comprises: shaping a composition containing a resin and a particulate carbon material with a content of the particulate carbon material being 50% by mass or less into a sheet by pressure application to provide a primary sheet having a tensile strength of 1.5 MPa or less (hereinafter also referred to as the "primary sheet shaping step"); and obtaining a laminate comprising two or more layers formed either by stacking a plurality of the primary sheets on top of each other or by folding or rolling the primary sheet (hereinafter also referred to as the "laminate forming step").

- Primary Sheet Shaping Step -

In the primary sheet shaping step, a composition containing a resin and a particulate carbon material, and optionally a fibrous carbon material and/or an additive, is shaped into a sheet by pressure application to provide a primary sheet.

-- Composition --

The composition may be prepared by mixing a resin and a particulate carbon material with an optional fibrous carbon material and/or additive. The resin, carbon material, and additive can be the resin, particulate carbon material, fibrous carbon material, and additive mentioned above which may be included in the at least one primary sheet forming the disclosed laminate. It should be noted that when a cross-linked resin is used as the resin for the secondary sheet, a primary sheet may be formed using a composition containing a cross-linked resin, or may be formed using a composition containing a cross-linkable resin and a curing agent and, after the primary sheet shaping step, the cross-linkable resin may be cross-linked to introduce the cross-linked resin into the secondary sheet.

Mixing can be effected by any means, e.g., using a mixing device known in the art, such as kneader, roll, Henschel mixer, or Hobart mixer. Mixing may be effected in the presence of a solvent such as ethyl acetate. A resin may be previously dissolved or dispersed in the solvent to obtain a resin solution, and the solution may be mixed with another carbon material and an optional additive. The mixing time may be, for example, from 5 minutes to 6 hours. The mixing temperature may be, for example, from 5 °C to 150 °C.

Of these components, because fibrous carbon material is easy to aggregate and is less dispersive, it is not easily dispersed well in the composition when mixed as it is with other components such as resin and expanded graphite. On the other hand, when fibrous carbon material is mixed with other components such as resin and expanded graphite in the form of a dispersion liquid dispersed in a solvent (dispersion medium), occurrence of aggregation can be suppressed. In this case, however, a large amount of solvent is used for, for example, coagulating the solid content after the mixing to obtain a composition, and there is a possibility that the amount of the solvent used for preparing the composition will increase. To avoid this, when a fibrous carbon material is to be blended in a composition used for forming a primary sheet, it is preferred that the fibrous carbon material is mixed with other components in the form of an aggregate (readily dispersible aggregate) which is obtained by removing the solvent from a dispersion liquid of the fibrous carbon material dispersed in solvent (dispersing medium). The aggregate of fibrous carbon material obtained by removing the solvent from a dispersion liquid of the fibrous carbon material is a highly readily dispersible aggregate because it is composed of a fibrous carbon material once dispersed in solvent and is more dispersible than an aggregate of the fibrous carbon material before dispersed into solvent. Thus, when such a readily dispersible aggregate is mixed with other components such as resin and expanded graphite, it is possible to allow the fibrous carbon material to be well dispersed in the composition efficiently without using large volumes of solvent.

Here, the dispersion liquid of the fibrous carbon material is obtained by, for example, subjecting a coarse dispersion liquid obtained by adding a fibrous carbon material to a solvent to a dispersion treatment that brings about a cavitation effect or a crushing effect. A dispersion treatment that brings about a cavitation effect utilizes shock waves caused by the rupture of vacuum bubbles formed in water when high energy is applied to the liquid. Specific examples of the dispersion treatment that brings about a cavitation effect include those using an ultrasonic homogenizer, a jet mill, and a high shear stirring device. In addition, the dispersion treatment that brings about a crushing effect is a dispersion method in which shearing force is applied to the coarse dispersion liquid to crush and disperse the aggregate of the fibrous carbon material, and by applying back pressure to the coarse dispersion liquid, fibrous carbon material is uniformly dispersed in a solvent while suppressing generation of bubbles. The dispersion treatment that brings about a crushing effect can be performed using a commercially available dispersion system (e.g., "BERYU SYSTEM PRO", trade name, produced by Beryu Corp.).

Removal of the solvent from the dispersion liquid can be carried out using a known solvent removal method such as drying or filtration, yet from the viewpoint of rapid and efficient removal of the solvent, filtration such as reduced pressure filtration is preferred.

-- Formation of Composition --

Then, the composition thus prepared may be shaped into a sheet by pressure application optionally after degassing and crushing. When solvent has been used during mixing, it is preferred to remove the solvent before shaping the composition into a sheet. For example, when defoaming is performed under vacuum, solvent can be removed at the same time as defoaming.

Any method can be used for shaping of the composition as long as pressure is applied. The composition can be shaped into a sheet by shaping methods known in the art, such as pressing, rolling, or extruding. In particular, it is preferred that the composition is shaped into a sheet by rolling, more preferably by passing the composition between rolls with the composition sandwiched between protection films. Any protection film can be used, for example, sandblasted polyethylene terephthalate films can be used. Roll temperature can be from 5 °C to 150 °C.

-- Primary Sheet --

In the primary sheet obtained by shaping the composition into a sheet by pressure application, the carbon material is aligned mainly in the in-plane direction and this configuration is presumed to contribute to improved heat conductivity particularly in the in-plane direction.

The thickness of the primary sheet is not particularly limited, and may be, for example, from 0.05 mm to 2 mm.

From the viewpoint of further improving the heat conductivity of the secondary sheet, the thickness of the primary sheet is preferably more than 20 times but not more than 5000 times the average particle diameter of the particulate carbon material.

- Laminate Forming Step -

In the laminate forming step, a laminate comprising two or more layers formed either by stacking a plurality of the primary sheets obtained in the primary sheet shaping step on top of each other or by folding or rolling the primary sheet is provided. Formation of a laminate by folding of the primary sheet can be accomplished by any means, for example, a folding device can be used to fold the primary sheet at a constant width. Formation of a laminate by rolling of the primary sheet is not particularly limited, and may be performed by rolling the primary sheet around an axis parallel to the transverse or longitudinal direction of the primary sheet.
In the laminate obtained in the laminate forming step, generally, the adhesive force between the surfaces of the primary sheet(s) is sufficiently obtained by the pressure applied upon stacking, folding, or rolling of the primary sheet(s). However, in the case where the adhesive strength is insufficient or when it is necessary to sufficiently suppress the interlayer peeling of the laminate, the laminate forming step may be carried out in a state where the surfaces of the primary sheet(s) are slightly dissolved with a solvent, or in a state where an adhesive is applied to, or an adhesive layer is provided on, the surfaces of the primary sheet(s).
Any solvent can be used to dissolve the surfaces of the primary sheet(s), and any solvent known in the art capable of dissolving the resin component included in the primary sheet(s) can be used.
Any adhesive can be applied to the surfaces of the primary sheet(s), for example, a commercially available adhesive or tacky resin can be used. Of them, preferred adhesives are resins having the same composition as the resin component included in the primary sheet(s). The thickness of the adhesive applied to the surfaces of the primary sheet(s) can be, for example, from 10 $\mu$m to 1,000 $\mu$m.
Furthermore, any adhesive layer can be provided on the surfaces of the primary sheet(s), for example, a double-sided tape can be used.
From the viewpoint of preventing delamination, it is preferred that the obtained laminate is pressed in the stacking direction at a pressure of 0.05 MPa to 1.0 MPa at 20 °C to 200 °C for 1 minute to 30 minutes.
When the fibrous carbon material has been added to the composition or expanded graphite has been used as the particulate carbon material, in a laminate obtained by stacking, folding, or rolling primary sheet(s), it is presumed that the expanded graphite and the fibrous carbon material are aligned in a direction substantially perpendicular to the stacking direction.

<Method of Producing Secondary Sheet>

The method of producing a laminate according to the present disclosure comprises slicing the laminate thus obtained at an angle of 45° or less relative to the stacking direction to provide a secondary sheet (hereinafter also referred to as the "slicing step").

- Slicing Step -

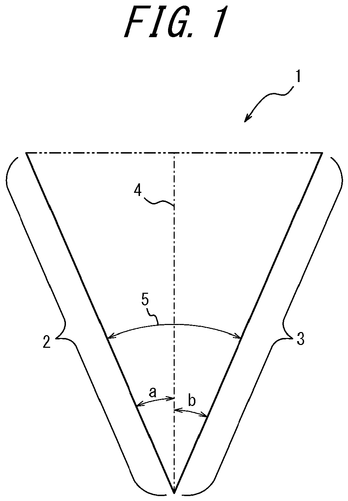

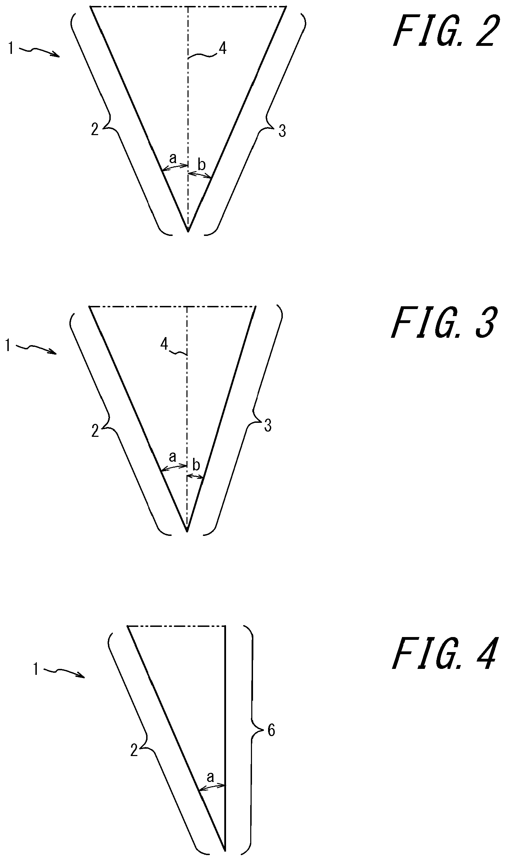

In the slicing step, the laminate obtained in the laminate forming step is sliced at an angle of 45° or less relative to the stacking direction to provide a secondary sheet formed of a sliced piece of the laminate. Any method can be used to slice the laminate, e.g., multi-blade method, laser processing method, water jet method, or knife processing method can be used, with the knife processing method being preferred because the thickness of the secondary sheet can be easily made uniform. Any cutting tool can be used to slice the laminate, e.g., a slicing member which has a smooth disk surface with a slit and a blade protruding from the slit (e.g., a plane or slicer equipped with a sharp blade) can be used.
Embodiments of a blade usable as the above-described blade will now be described in detail below with reference to the drawings.
A single blade having a blade portion may be "double-edged" in which both the front and back sides of the blade edge are cutting edges, or may be "single-edged" in which only the front side of the blade is a cutting edge. Referring to FIGS. 1 to 4 which are cross-sectional views of the blade edge 1, both edges are cutting edges 2 and 3 on both left and right sides in the case of a double-edged blade (FIGS. 1 to 3), and only one side of the left and right sides corresponding to the front side is a cutting edge 2 in the case of a single-edged blade (FIG. 4).
The cross-sectional shape of the blade edge 1 is not particularly limited, and may be asymmetric or symmetrical with respect to a central axis 4 passing through the extreme distal end of the blade edge 1. As used herein, a blade having a blade edge symmetrical in shape with respect to the central axis is referred to as a "symmetrical blade" (FIG. 2), while a blade having a blade edge asymmetrical in shape with respect to the central axis as an "asymmetrical blade" (FIG. 3). In each cross-sectional view of the blade edge, the angles formed by the right and left cutting edges with respect to the central axis are respectively referred to as "central angles", and the sum of the central angles is the angle of the blade edge (hereinafter also referred to as the "blade angle"). For example, in FIGS. 1 to 3 which are cross-sectional views of blade edges of double-edged blades, the angle formed by the cutting edge 2 on the left side with respect to the center axis 4 is a central angle a, and the angle formed by the cutting edge 3 on the right side with respect to the center axis 4 is a central angle b. The blade angle is preferably 60° or less. Although not particularly limited, the central angles a and b can preferably be selected such that the blade angle is 60° or less. For example, in the case of a double-edged symmetrical blade as illustrated in FIG. 2, when the central angles a and b on both sides are 20°, the blade angle is 40° which is the sum of a and b. In the case of a double-edged asymmetrical blade as illustrated in FIG. 3, the central angles a and b can be selected such that they are different from each other by more than 0°, preferably such that the sum of a and b (blade angle) is 60° or less. In the case of an asymmetrical blade as illustrated in FIG. 4, when the central angle a on one side is larger than 0° and the central angle b on the other side is 0°, the blade is a single-edged blade having one cutting edge 2 and one back edge 6.

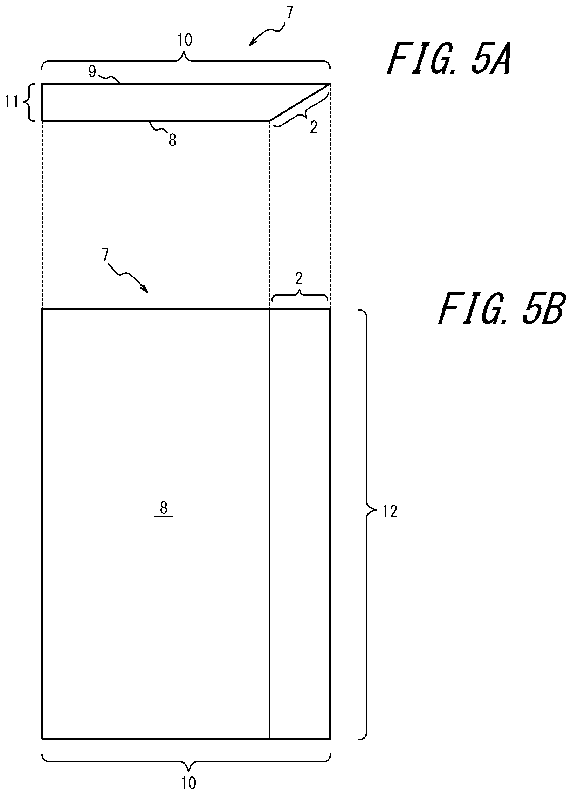

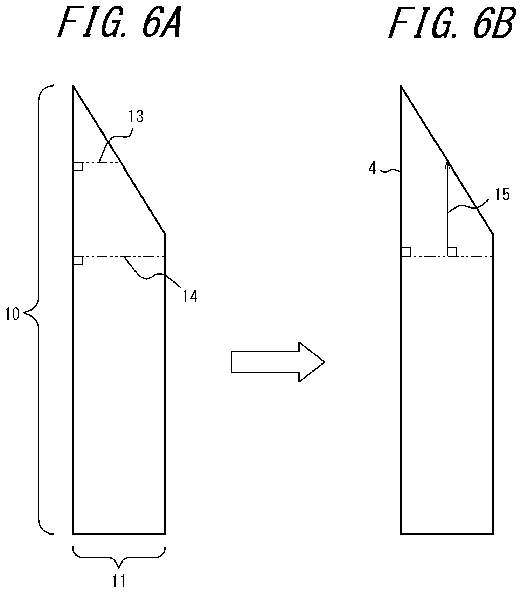

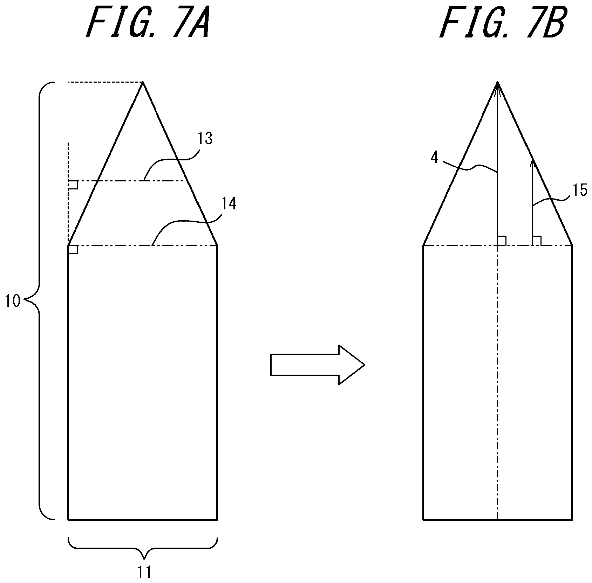

The central axis 4 is set as follows. In FIG. 5A in which the entire blade 7 is viewed from the side, the distance from the extreme distal end of the blade edge to the root of the blade is defined as "blade height" 10, and from a front side 8 to a back side 9 of the blade as "blade thickness" 11. FIG. 5B is a view of the entire blade 7 illustrated in FIG. 5A as viewed from the front side 8 of the blade. In FIGS. 6A-6B and 7A-7B in which the entire blade is seen from the side, in the cross section of the blade in a plane perpendicular to the blade height 10, one of perpendicular lines 13 drawn in a direction from the blade height 10 toward the blade thickness 11 that is the longest is defined as a "reference line" 14 (FIGS. 6A and 7A). Then, one of perpendicular lines 15 drawn in a direction from the reference line 14 toward the tip of the blade that is the longest and its extension are defined as the "central axis" 4 (FIGS. 6B and 7B). As described above, the central axis 4 passes through the extreme distal end of the blade edge.

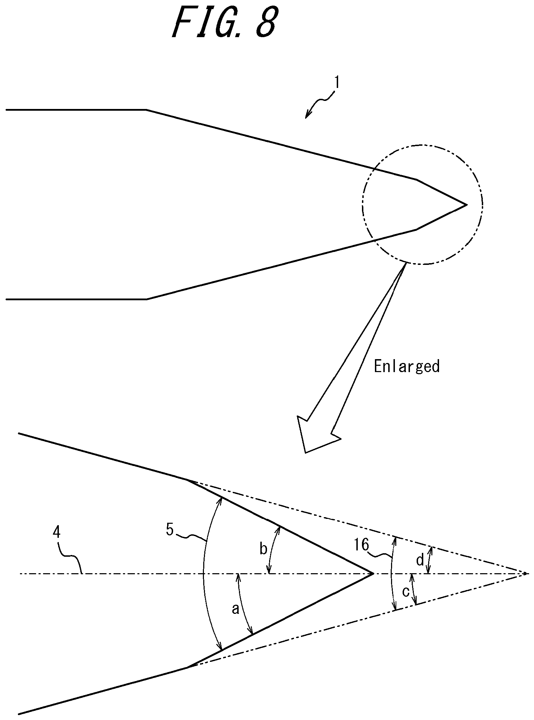

Further, the blade may be a single-step blade in which one cutting edge 2 or 3 has one face with respect to the central axis 4 of the blade as illustrated in FIGS. 1 to 7B, or may be a double-step blade in which one cutting edge 2 or 3 has two faces at different inclination angles with respect to the central axis 4 of the blade as illustrated in FIG. 8. In the case of a double-step blade, the sum of the central angles a and b forming the extreme distal end (second step) of the blade edge is the blade angle 5. As used herein, the blade angle of the double-step blade is referred to as a "blade angle $\alpha$" for the sake of convenience. Further, the central angles that are formed by the two-dot chain lines extending from the faces at the inclination angle on the root side (first step) of the blade edge toward the extreme distal end of the blade edge with respect to the center axis 4 of the blade are defined as c and d, and the blade angle 16 which is the sum of c and d is conveniently referred to as a "blade angle $\beta$". In the double-step blade, the blade angles $\alpha$ and $\beta$ are different from each other, and are preferably larger than 0° and not larger than 60° (0° < blade angle $\alpha$, blade angle $\beta$ $\leq$ 60°). Although not particularly limited, it is preferable that the blade angle $\alpha$ is larger than the blade angle $\beta$ (blade angle $\alpha$ > blade angle $\beta$). The reason is that this setting provides a curling suppressing effect. On the other hand, when the blade angle $\alpha$ is smaller than the blade angle $\beta$ (blade angle $\alpha$ < blade angle $\beta$), although the tip becomes sharp, there is a disadvantage that the blade is easily broken due to locally applied force. Therefore, the blade angle $\alpha$ and the blade angle $\beta$ preferably satisfy the relationship 0° < blade angle $\beta$ < blade angle $\alpha$ $\leq$ 60°.

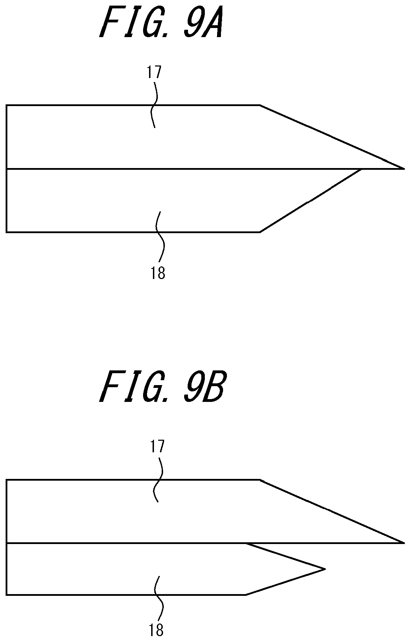

The number of blades constituting the blade portion is not particularly limited, and the blade portion may have, for example, a single-blade configuration composed of one blade or a double-blade configuration composed of two blades. As illustrated in FIGS. 9A and 9B, a double-blade configuration is composed of one front blade 17 and one back blade 18, and the front and back blades 17 and 18 are arranged in contact with each other. At the time of cutting, one of the blades located on the side close to the object to be cut is the front blade 17 and the other far from the object is the back blade 18. As long as the front and back blades function as blades (that is, they have a cutting function), the extreme distal ends of the respective blade edges projecting from the slit portion may have the same or different heights (that is, they may be aligned or relatively shift.)

In addition, the two blades may be single- or double-edged, respectively. For example, both the front blade and the back blade may be single-edged (FIG. 9A), both the front blade and the back blade may be double-edged, or one of the front blade or the back blade may be single-edged and the other double-edged (FIG. 9B). In the case where one or both of the front blade and the back blade are single-edged, as long as the double-blade configuration functions as blades (that is, they have a cutting function), the side of one blade on which it comes into contact with the other blade is not limited to any of the cutting edge side (front side) or the back edge side (back side).

For example, FIG. 9A illustrates one embodiment of the double-blade configuration in which both the front blade 17 and the back blade 18 are single-edged, contact each other on the back edge side, and are arranged in an offset manner such that the extreme distal end of the edge of the back blade is positioned lower than (that is, below) the extreme distal end of the edge of the front blade. FIG. 9B illustrates another embodiment of the double-blade configuration in which the front blade 17 is single-edged and the back blade 18 is double-edged, the front blade is in contact with the back blade on the back edge side, and the extreme distal end of the edge of the back blade is positioned lower than (that is, below) the extreme distal end of the edge of the front blade.

In the case where one or both of the two blades are double-edged, the two blades may be symmetrical or asymmetrical blades.

Further, the two blades may be a single-step blade or a double-step blade, respectively.

In addition, the material of the blades is not particularly specified and may be metal, ceramic, or plastic, yet particularly from the viewpoint of resisting impact, cemented carbide is desirable. For the purpose of improving slipperiness and machinability, silicone, or fluorine may be coated on the surface of the blade.

From the perspective of increasing the heat conductivity of the secondary sheet, the angle at which the laminate is sliced is preferably 30° or less relative to the stacking direction, more preferably 15° or less relative to the stacking direction, even more preferably substantially 0° relative to the stacking direction (i.e., along the stacking direction).

From the perspective of increasing the easiness of slicing, the temperature of the laminate at the time of slicing is preferably -20 °C to 40 °C, more preferably 10 °C to 30 °C. For the same reason, the laminate is preferably sliced while applying a pressure in a direction perpendicular to the stacking direction, more preferably while applying a pressure of 0.1 MPa to 0.5 MPa in a direction perpendicular to the stacking direction. It is presumed that the particulate carbon material and the fibrous carbon material are aligned in the thickness direction in the secondary sheet thus obtained. Thus, the secondary sheet prepared through the above steps has not only heat conductivity in thickness direction but also high electrical conductivity.

Alternatively, a plurality of secondary sheets prepared as described above may be stacked in the thickness direction and integrated by standing for a predetermined period of time, and the resultant may be used as the secondary sheet. It is presumed that the particulate carbon material and the fibrous carbon material are still aligned in the thickness direction in the secondary sheet thus obtained. Therefore, by overlapping a plurality of the secondary sheets prepared as described above with one another in the thickness direction to integrate them, it is possible to obtain a secondary sheet having a desired thickness according to the purpose of use without deteriorating the heat conductivity or electrical conductivity in the thickness direction.

(Application of Secondary Sheet)

Since the secondary sheet produced using the disclosed laminate is excellent in heat conductivity, strength, and electrical conductivity and less susceptible to curling (warping), it can be suitably used as, for example, a composite material sheet or a heat conductive sheet. The composite material sheet and the heat conductive sheet produced using the disclosed secondary sheet can be suitably used as, e.g., a heat dissipation material, a heat dissipation component, a cooling component, a temperature control component, an electromagnetic wave shielding member, an electromagnetic wave absorbing member, or a rubber sheet for thermal pressure bonding to be interposed between the object to be bonded by pressure and a thermal pressure bonding device, used in various devices and apparatus.

As used herein, the various devices and apparatus are not particularly limited, and examples thereof include electronic devices such as servers, server personal computers, and desktop personal computers; portable electronic devices such as notebook computers, electronic dictionaries, PDAs, mobile phones, and portable music players; display devices such as liquid crystal displays (including backlights), plasma displays, LEDs, organic EL devices, inorganic EL devices, liquid crystal projectors, and watches; image forming devices such as inkjet printers (ink heads), electrophotographic devices (developing devices, fixing devices, heat rollers, and heat belts); semiconductor-related parts such as semiconductor devices, semiconductor packages, semiconductor sealing cases, semiconductor die bonding, CPUs, memory, power transistors, and power transistor cases; circuit boards such as rigid circuit boards, flexible circuit boards, ceramic circuit boards, build-up circuit boards, and multilayer circuit boards (circuit boards include printed circuit boards); manufacturing apparatus such as vacuum processing apparatus, semiconductor manufacturing apparatus, display device manufacturing apparatus; heat insulation devices such as heat insulation materials, vacuum heat insulation materials, and radiant heat insulating materials; data recording devices such as DVDs (optical pickups, laser generating devices, and laser light receiving devices) and hard disk drives; image recording devices such as cameras, video cameras, digital cameras, digital video cameras, microscopes, and CCDs; and battery devices such as charging devices, lithium ion batteries, and fuel cells.

(Heat Dissipation Device)

When used as a heat conductive sheet, the secondary sheet produced using the disclosed laminate may be interposed between a heat source and a heat radiator such as a heat sink, a radiation plate, or a radiation fin to provide a heat dissipation device. The operating temperature of the heat dissipation device is preferably not higher than 250 °C, and more preferably in the range of -20 °C to 200 °C. When the use temperature exceeds 250 °C, the flexibility of the resin component sharply decreases, and the heat dissipation characteristics may deteriorate in some cases. Examples of the heat source at this operating temperature include a semiconductor package, a display, an LED, and an electric lamp.

On the other hand, examples of the heat radiator include an aluminum or copper block connected to a heat sink or a heat pipe utilizing an aluminum or copper fin or plate, an aluminum or copper block in which cooling liquid circulates, and a Peltier element and an aluminum or copper block provided therewith.

The heat dissipation device can be obtained by interposing the secondary sheet between the heat source and the heat radiator and bringing the respective surfaces into contact with each other. There are no particular restrictions on the contacting method as long as the secondary sheet is interposed between the heat source and the heat radiator and they can be fixed in a state in which they are closely attached to each other sufficiently. From the viewpoint of maintaining close attachment, however, a way in which the pressing force is sustained is preferable, such as screwing via a spring, clipping with a clip, or the like.

EXAMPLES

In the following, this disclosure will be described with reference to Examples, which however shall not be construed as limiting by any means. In the following, "%" and "parts" used in expressing quantities are by mass, unless otherwise specified.

In Examples and Comparative Examples, a pre-heat conductive sheet as a primary sheet, a laminate, and a heat conductive sheet as a secondary sheet were prepared, the tensile strength of the pre-heat conductive sheet (primary sheet) was measured, and the degree of curling of the conductive sheet (secondary sheet) was evaluated. For the measurement and evaluation, the following methods were used, respectively.

(Evaluation method)

<Tensile Strength>

A pre-heat conductive sheet was punched out with a dumbbell No. 2 in accordance with JIS K6251 to prepare a sample piece. Using a tensile tester ("AG-IS 20 kN", trade name, produced by Shimadzu Corporation), each sample piece was pinched at a portion of 1 cm from both ends, and pulled at a temperature of 23 °C in a direction perpendicular to a normal line extending from the surface of the sample piece at a tension speed of 500 mm/min, and the breaking strength (tensile strength) was measured.

<Curling Evaluation>

A weight (55 mm × 55 mm, 65 g) was placed on a 50 mm × 50 mm heat conductive sheet obtained by slicing for 10 seconds. After removal of the weight, the curl height was measured with a digital caliper ("ABS inside digimatic caliper", trade name, produced by Mitutoyo Corporation), and the measured value (in millimeters) was divided by 50 mm, which is the length of one side of the heat conductive sheet, and the result was evaluated. Note that heat conductive sheets that curled one or more times after removal of the weight are indicated as "unevaluable".

<Film Thickness>

Measurement was made of the film thickness at ten points using a film thickness meter ("Digimatic Thickness", trade name, produced by Mitutoyo Corporation), and the average of the results is listed in the table.

(Preparation of Fibrous Carbon Nanostructures A including CNTs) Fibrous carbon nanostructures A including SGCNTs were prepared by the super growth method in accordance with the teachings of WO 2006/011655. The fibrous carbon nanostructures A thus obtained had a G/D ratio of 3.0, a BET specific surface area of 800 $m^2/g$, and a mass density of 0.03 $g/cm^3$. As a result of measuring diameters for 100 randomly-selected fibrous carbon nanostructures A using a transmission electron microscope, it was found that the average diameter (Av) was 3.3 nm, a value obtained by multiplying the sample standard deviation of diameters ($\sigma$) by three ($3\sigma$) was 1.9 nm, the ratio ($3\sigma/Av$) was 0.58, and the average length was 100 $\mu$m. It was also revealed that the fibrous carbon nanostructures A thus obtained were mainly composed of single-walled CNTs (also referred to as "SGCNTs").

(Preparation of Readily Dispersible Aggregate of Fibrous Carbon Nanostructures A)

<Production of Dispersion Liquid>

Here, 400 mg of fibrous carbon nanostructures A as a fibrous carbon material was weighed out, mixed in 2 L of methyl ethyl ketone as a solvent, and stirred for 2 minutes with a homogenizer to obtain a coarse dispersion liquid. Using a wet jet mill ("JN-20", trade name, produced by Jokoh Co., Ltd.), the resulting crude dispersion liquid was passed through a 0.5 mm flow path of the wet jet mill for 2 cycles at a pressure of 100 MPa, and the fibrous carbon nanostructures A were dispersed in methyl ethyl ketone. Then, a dispersion A having a solids concentration of 0.20% by mass was obtained.

<Removal of Solvent>

Then, the resultant dispersion A was subjected to vacuum filtration using Kiriyama Filter Paper (No. 5A) to obtain a sheet-like readily dispersible aggregate.

(Example 1)

<Preparation of Composition>

Here, 0.1 parts by mass of a readily dispersible aggregate of carbon nanostructures A as a fibrous carbon material and 50 parts by mass of expanded graphite as an particulate carbon material ("EC-100", trade name, produced by Ito Graphite Co., Ltd., average particle diameter: 190 $\mu$m), and 100 parts by mass of a thermoplastic fluororubber that is liquid at ordinary temperature ("Daiel G-101", trade name, produced by Daikin Industries, Ltd.) as a resin were charged into a Hobart mixer ("Model ACM-5 LVT", trade name, produced by Kodaira Seisakusho Co., Ltd., capacity: 5 L), heated to 80 °C, and mixed for 30 minutes. The mixed composition was crushed for 1 minute with a Wonder Crush/Mill ("D3V-10", trade name, produced by Osaka Chemical Co., Ltd.).

<Preparation of Pre-heat Conductive Sheet>

Then, 5 g of the crushed composition was sandwiched between sandblasted PET films (protective films) having a thickness of 50 $\mu$m and shaped by rolling under the conditions of a roll gap of 550 $\mu$m, a roll temperature of 50 °C, a roll line pressure of 50 kg/cm, and a roll speed of 1 m/min, and as a result a pre-heat conductive sheet having a thickness of 500 $\mu$m was obtained. The tensile strength of the obtained pre-heat conductive sheet was measured according to the above evaluation method. The results are listed in Table 1.

<Preparation of Laminate>

The obtained pre-heat conductive sheet was cut into 6 cm $\times$ 6 cm $\times$ 500 $\mu$m pieces, 120 pieces were stacked in the thickness direction and thermal pressure-bonded by pressing at 0.1 MPa at 120 °C for 3 minutes, and as a result a laminate having a thickness of about 6 cm was obtained.

<Preparation of Heat Conductive Sheet>

Then, a cross section of 6 cm $\times$ 6 cm of the laminate of pre-heat conductive sheet(s) was sliced using a wood working slicer ("Superfinishing Planer Super Mecha S", trade name, produced by Marunaka Tekkosho Inc.) to obtain sliced sheets (secondary sheets) having thicknesses of 250 $\mu$m and 500 $\mu$m, respectively. The thickness of the secondary sheet was controlled by adjusting the protrusion of the knife of the wood working slicer. The knife used had a double-blade configuration in which two single-edged blades are in contact with each other on the opposite side (back edge) of the cutting edge and arranged in a manner that the extreme distal end of the edge of the front blade is positioned 0.5 mm higher than the extreme distal end of the edge of the back blade. For slicing, the knife was fixed under the conditions of a laminate temperature of 10 °C, a processing speed of 54 m/min, and a cutting edge angle of the front blade of 21°, and a clearance angle of 3°, and moved horizontally while applying a compressive force of 0.3 MPa vertically to the resin shaped product.
For each obtained heat conductive sheet, the degree of curling was evaluated according to the above evaluation method. The results are listed in Table 1.

(Example 2)

A pre-heat conductive sheet and a heat conductive sheet were produced in the same manner as in Example 1 except that the knife of the wood working slicer was changed to one with a single-edged blade (blade angle 21°). Then, the tensile strength of the pre-heat conductive sheet was measured and the degree of curling of the heat conductive sheet was evaluated. The results are listed in Table 1.

(Example 3)

A pre-heat conductive sheet and a heat conductive sheet were produced in the same manner as in Example 1 except that the pressure bonding method for the pre-heat conductive sheet was not thermal pressure bonding but one by one bonding with a double-sided tape ("NeoFix-10", trade name, produced by Nichiei Kakoh Co., Ltd.). Then, the tensile strength of the pre-heat conductive sheet was measured and the degree of curling of the heat conductive sheet was evaluated. The results are listed in Table 1.

(Example 4)

A pre-heat conductive sheet and a heat conductive sheet were produced in the same manner as in Example 1 except that 90 parts by mass of a thermoplastic fluororubber that is liquid at ordinary temperature ("Daiel G-101", trade name, produced by Daikin Industries, Ltd.) and 10 parts by mass of a solid thermoplastic fluororubber that is solid at ordinary temperature ("Daiel G-704 BP", trade name, produced by Daikin Industries, Ltd.) diluted with methyl ethyl ketone (MEK) to have a solid content of 30% were used as a resin, and that the MEK was removed by vacuum defoaming before forming the pre-heat conductive sheet. Then, the tensile strength of the pre-heat conductive sheet was measured and the degree of curling of the heat conductive sheet was evaluated. The results are listed in Table 1.

(Example 5)

A pre-heat conductive sheet and a heat conductive sheet were produced in the same manner as in Example 1 except that the amount of the particulate carbon material was changed to 70 parts by mass, and the tensile strength of the pre-heat conductive sheet was measured and the degree of curling of the heat conductive sheet was evaluated. The results are listed in Table 1.

(Example 6)

A pre-heat conductive sheet and a heat conductive sheet were produced in the same manner as in Example 1 except that 70 parts by mass of a thermoplastic fluororubber that is liquid at ordinary temperature ("Daiel G-101", trade name, produced by Daikin Industries, Ltd.) and 30 parts by mass of a thermoplastic fluororubber that is solid at ordinary temperature ("Daiel G-704 BP", trade name, produced by Daikin Industries, Ltd.) diluted with methyl ethyl ketone (MEK) to have a solid content of 30% were used as resins, that the amount of the particulate carbon material was changed to 70 parts by mass, and that the MEK was removed by vacuum defoaming before forming the pre-heat conductive sheet. Then, the tensile strength of the pre-heat conductive sheet was measured and the degree of curling of the heat conductive sheet was evaluated. The results are listed in Table 1.

(Example 7)

The tensile strength of the pre-heat conductive sheet was measured and the degree of curling of the heat conductive sheet was evaluated in the same manner as in Example 1 except that in the production of the heat conductive sheet, the laminate was sliced by, instead of using a plane device, vertically lowering a single blade (tip angle = 30°) with a single blade at a speed of 3 mm/s using a pushing device (produced by Finetec Co., Ltd.). The results are listed in Table 1.

(Comparative Example 1)

<Preparation of Composition>

In this case, 0.1 parts by mass of a readily dispersible aggregate of carbon nanostructures A as a fibrous carbon material, 85 parts by mass of expanded graphite ("EC-50", trade name, produced by Ito Graphite Industry Co., Ltd.) as a particulate carbon material, 40 parts by mass of a thermoplastic fluororubber that is solid at ordinary temperature ("Daiel G-704BP", trade name, produced by Daikin Industries, Ltd.) as a resin, 45 parts by mass of a thermoplastic fluorine rubber that is liquid at ordinary temperature ("Daiel G-101", trade name, produced by Daikin Industries, Ltd.) as a resin, and 5 parts by mass of sebacic acid ester ("DOS", trade name, produced by Daihachi Chemical Industry Co., Ltd.) as a plasticizer were stirred for 5 minutes in the presence of 100 parts by mass of ethyl acetate as a solvent using a Hobart mixer ("ACM-5 LVT type", trade name, produced by Kodaira Seisakusho Co., Ltd.). Then, the obtained mixture was vacuum defoamed for 30 minutes, and at the same time as defoaming, ethyl acetate was removed to obtain a composition. The obtained composition was charged into a disintegrator and disintegrated for 10 seconds.

<Preparation of Pre-heat Conductive Sheet, Laminate, and Heat Conductive Sheet>

A pre-heat conductive sheet and a heat conductive sheet were produced following the subsequent procedure as in Example 1 except that the knife of the wood working slicer was changed to one with a single-edged blade in the production process of the heat conductive sheet, and the tensile strength of the pre-heat conductive sheet was measured and the degree of curling of the heat conductive sheet was evaluated. The results are listed in Table 1.

(Comparative Example 2)

A pre-heat conductive sheet and a heat conductive sheet were manufactured in the same manner as in Comparative Example 1 except that the knife of the wood working slicer was changed to one with single-edged double blades. Then, the tensile strength of the pre-heat conductive sheet was measured and the degree of curling of the heat conductive sheet was evaluated. The results are listed in Table 1.

Table 1

| | | | Example 1 | Example 2 | Example 3 | Example 4 | Example 5 | Example 6 | Example 7 | Comparative Example 1 | Comparative Example 2 |
|---|---|---|---|---|---|---|---|---|---|---|---|
| Primary sheet | Resin | Fluororesin G-101 [parts by mass] | 100 | 100 | 100 | 90 | 100 | 70 | 100 | 40 | 40 |
| | | Fluororesin G-704BP [parts by mass] | - | - | - | 10 | - | 30 | - | 45 | 45 |
| | Plasticizer | Sebacic acid ester [parts by mass] | - | - | - | - | - | - | - | 5 | 5 |
| | Particulate carbon material | EC-100, particle diameter 190 [parts by mass] | 50 | 50 | 50 | 50 | 70 | 70 | 50 | - | - |
| | | $\mu$m EC-50, particle diameter 250 $\mu$m [parts by mass] | | | | - | | | | 85 | 85 |
| | Fibrous carbon material | Carbon nanostructures A [parts by mass] | 0.1 | 0.1 | 0.1 | 0.1 | 0.1 | 0.1 | 0.1 | 0.1 | 0.1 |
| | Content of particulate carbon material [% by mass] | | 33 | 33 | 33 | 33 | 41 | 41 | 33 | 50 | 50 |
| | Content of fibrous carbon material [% by mass] | | 0.067 | 0.067 | 0.067 | 0.067 | 0.059 | 0.059 | 0.067 | 0.057 | 0.057 |
| | Tensile strength of primary sheet [MPa] | | 0.46 | 0.46 | 0.46 | 0.88 | 0.63 | 1.5 | 0.46 | 1.83 | 1.83 |
| Production | Adhesion method for primary sheet | | thermal pressure bonding | thermal pressure bonding | double-sided tape | thermal pressure bonding | thermal pressure bonding | thermal pressure bonding | thermal pressure bonding | thermal pressure bonding | thermal pressure bonding |
| | Slicing device for laminate | | plane | plane | plane | plane | plane | plane | pushing device | plane | plane |
| | Blade of slicing device | | single-edged double-blade | single-edged single-blade | single-edged double-blade | single-edged double-blade | single-edged double-blade | single-edged double-blade | single-edged single-blade | single-edged single-blade | single-edged double-blade |
| | Laminate slicing angle relative to stacking direction [°] | | 21 | 21 | 21 | 21 | 21 | 21 | 30 | 21 | 21 |

EP 3 422 832 B1

19

(continued)

| Evaluation | Curl index | Thickness of secondary sheet 500 $\mu$m | Example 1 | Example 2 | Example 3 | Example 4 | Example 5 | Example 6 | Example 7 | Comparative Example 1 | Comparative Example 2 |
|---|---|---|---|---|---|---|---|---|---|---|---|
| | | | 0.07 | 0.07 | 0.08 | 0.11 | 0.19 | 0.25 | 0.05 | unevaluable | unevaluable |
| | | Thickness of secondary sheet 250 $\mu$m | 0.06 | 0.04 | 0.07 | 0.16 | 0.18 | 0.26 | 0.04 | unevaluable | unevaluable |

**EP 3 422 832 B1**

It can be seen from Table 1 that in the laminate of Examples 1 to 7 formed by primary sheet(s) (pre-heat conductive sheet(s)), each containing a resin and a particulate carbon material with a content of the particulate carbon material being 50 mass% or less, and each having a tensile strength of 1.5 MPa or less, curling of the resultant secondary sheet (heat conductive sheet) was sufficiently suppressed regardless of the slicing method and thickness. In contrast, it will be appreciated that in the laminate of Comparative Examples 1 and 2 formed by primary sheet(s) (pre-heat conductive sheet(s)), each containing a resin and a particulate carbon material with a content of the particulate carbon material being 50% by mass, but each having a tensile strength of more than 1.5 MPa, curling of the resultant secondary sheet (heat conductive sheet) was not suppressed irrespective of the slicing method or thickness, and the laminate had curled with more than one turn even after removal of the weight.

INDUSTRIAL APPLICABILITY

The laminate disclosed herein can be suitably used for production of a secondary sheet in which a particulate carbon material is aligned in the thickness direction and curling is sufficiently suppressed. The method of producing a laminate according to the present disclosure can provide a laminate usable for production of a secondary sheet in which a particulate carbon material is aligned in the thickness direction and curling is sufficiently suppressed. The disclosed method of producing a secondary sheet can also provide a secondary sheet that contains a particulate carbon material aligned in the thickness direction and in which curling is sufficiently suppressed. The secondary sheet produced by using the disclosed laminate that contains a particulate carbon material aligned in the thickness direction and in which curling is sufficiently suppressed, is preferably usable as, for example, a heat conductive sheet.

REFERENCE SIGNS LIST

1    blade edge
2    cutting edge
3    cutting edge
4    central axis
5    blade angle
6    back edge
7    entire blade
8    front
9    back
10   blade height
11   blade thickness
12   blade width
13   perpendicular line
14   reference line
15   perpendicular line
16   blade angle
17   front blade
18   back blade

**Claims**

1. A secondary sheet comprising a resin and a particulate carbon material with a content of the particulate carbon material being 50% by mass or less such that the particulate carbon material is aligned in a thickness direction of the secondary sheet, wherein
   the resin comprises a thermoplastic resin that is liquid at a temperature of 23 °C;
   the particulate carbon material has an average diameter of 300 μm or less and comprises expanded graphite; and
   the secondary sheet has a curl index of 0.33 or less, where the curl index is obtained by, when the secondary sheet is formed into a square of 50 mm × 50 mm, a 65 g weight of 55 mm × 55 mm is placed on a flat surface thereof for 10 seconds, and the weight is then removed, dividing a curl height by 50 mm, which is the length of one side of the secondary sheet, where the curl height is measured in millimeters from the flat surface in a direction perpendicular to the flat surface.

2. The secondary sheet according to claim 1, wherein the resin consists of the thermoplastic resin that is liquid at the temperature of 23 °C.

3. The secondary sheet according to claim 1 or 2, wherein the secondary sheet has a thermal resistance of 0.20 °C/W or less under a pressure of 0.05 MPa.

4. The secondary sheet according to any one of claims 1 to 3, wherein a tack of the secondary sheet is 0.80 N or less, where the tack is measured as a force required to pull away a flat probe of $\phi$ 10 mm from the secondary sheet to be measured after the probe is pressed against the secondary sheet for 10 seconds under the temperature condition of 25 °C while applying a pressure of 0.5 N.

5. The secondary sheet according to any one of claims 1 to 4, wherein the secondary sheet has an Asker C hardness at 25 °C of 60 or more and 90 or less, where the Asker C hardness is measured at a predetermined temperature using a hardness tester according to the Asker C method specified in the Japan Rubber Association Standard.

6. A method of producing a secondary sheet comprising:

shaping a composition containing a resin comprising a thermoplastic resin that is liquid at a temperature of 23 °C and a particulate carbon material having an average diameter of 300 $\mu$m or less and comprising expanded graphite with a content of the particulate carbon material being 50% by mass or less into a sheet by pressure application to provide a primary sheet having a tensile strength of 1.5 MPa or less, wherein the tensile strength is measured according to JIS K6251;

obtaining a laminate comprising two or more layers formed either by stacking a plurality of the primary sheets on top of each other or by folding or rolling the primary sheet; and

slicing the laminate at an angle of 45° or less relative to the stacking direction to obtain the secondary sheet, wherein the secondary sheet has a curl index of 0.33 or less, where the curl index is obtained by, when the secondary sheet is formed into a square of 50 mm × 50 mm, a 65 g weight of 55 mm × 55 mm is placed on a flat surface thereof for 10 seconds, and the weight is then removed, dividing a curl height by 50 mm, which is the length of one side of the secondary sheet, where the curl height is measured in millimeters from the flat surface in a direction perpendicular to the flat surface.

**Patentansprüche**

1. Sekundäre Platte umfassend ein Harz und ein Harz und ein partikuläres Kohlenstoffmaterial mit einem Anteil des partikulären Kohlenstoffmaterials, welcher 50 Massen% oder weniger ist, sodass das partikuläre Kohlenstoffmaterial in einer Dickenrichtung der sekundären Platte ausgerichtet ist, wobei

das Harz ein thermoplastisches Harz, welches bei einer Temperatur von 23 °C flüssig ist, umfasst;

das partikuläre Kohlenstoffmaterial einen durchschnittlichen Durchmesser von 300 $\mu$m oder weniger aufweist und expandiertes Graphit umfasst; und

die sekundäre Platte einen Curl Index von 0,33 oder weniger aufweist, wobei der Curl Index erhalten wird durch, wenn die sekundäre Platte in ein 50 mm x 50 mm Quadrat geformt wird, ein 65 g Gewicht von 55 mm x 55 mm auf die flache Oberfläche davon für 10 Sekunden platziert wird, und das Gewicht dann entfernt wird, dividieren einer Curlhöhe durch 50 mm, welches die Länge einer Seite der sekundären Platte ist, wobei die Curlhöhe in Millimetern von der flachen Oberfläche in einer Richtung senkrecht zur Oberfläche gemessen wird.

2. Sekundäre Platte nach Anspruch 1, wobei das Harz aus dem thermoplastischen Harz, welches flüssig bei der Temperatur von 23 °C ist, besteht.

3. Sekundäres Platte nach Anspruch 1 oder 2, wobei die sekundäre Platte einen thermischen Widerstand von 0,20 °C/W oder weniger unter einem Druck von 0,05 MPa aufweist.

4. Sekundäre Platte nach einem der Ansprüche 1 bis 3, wobei eine Klebrigkeit der sekundären Platte 0,80 N oder weniger beträgt, wobei die Klebrigkeit gemessen wird als eine Kraft, welche erforderlich ist, um eine flache Probe von $\phi$ 10 mm von einer zu messenden sekundären Platte wegzuziehen, nachdem die Probe für 10 Sekunden unter der Temperaturbedingung von 25 °C gegen eine sekundäre Platte gedrückt wird, während ein Druck von 0,5 N angewandt wird.

**5.** Sekundäre Platte nach einem der Ansprüche 1 bis 4, wobei die sekundäre Platte eine Asker-C-Härte bei 25 °C von 60 oder mehr und 90 oder weniger aufweist, wobei die Asker-C-Härte bei einer vorbestimmten Temperatur unter Verwendung eines Härtetesters gemäß dem Asker-C-Verfahren, welches im Japan Rubber Association Standard spezifiziert ist, gemessen wird.

**6.** Verfahren zur Herstellung einer sekundären Platte umfassend:

Formen einer Zusammensetzung enthaltend ein Harz umfassend ein thermoplastisches Harz, welches bei einer Temperatur von 23 °C flüssig ist, und ein partikuläres Kohlenstoffmaterial, welches einen durchschnittlichen Durchmesser von 300 μm oder weniger aufweist, und expandiertes Graphit mit einem Anteil des partikulären Kohlenstoffmaterials, welcher 50 Massen% oder weniger beträgt, umfasst in eine Platte durch Druckanwendung, um eine primäre Platte mit einer Zugfestigkeit von 1,5 MPa oder weniger bereitzustellen, wobei die Zugfestigkeit gemäß JIS K6251 gemessen wird;
Erhalten eines Laminats umfassend zwei oder mehr Schichten, welches entweder durch Stapeln einer Mehrzahl des primären Platten aufeinander oder durch Falten oder Rollen der primären Platte gebildet wird; und
Schneiden des Laminats in einem Winkel von 45° oder weniger im Verhältnis zur Stapelrichtung, um eine sekundäre Platte zu erhalten, wobei die sekundäre Platte einen Curl Index von 0,33 oder weniger aufweist, wobei der Curl Index erhalten wird durch, wenn die sekundäre Platte in ein 50 mm x 50 mm Quadrat geformt wird, ein 65 g Gewicht von 55 mm x 55 mm auf die flache Oberfläche davon für 10 Sekunden platziert wird, und das Gewicht dann entfernt wird, dividieren einer Curlhöhe durch 50 mm, welches die Länge einer Seite der sekundären Platte ist, wobei die Curlhöhe in Millimetern von der flachen Oberfläche in einer Richtung senkrecht zur Oberfläche gemessen wird.

## Revendications

**1.** Feuille secondaire comprenant une résine et un matériau de carbone particulaire ayant une teneur du matériau de carbone particulaire étant de 50 % en masse ou moins de sorte que le matériau de carbone particulaire est aligné dans une direction d'épaisseur de la feuille secondaire, dans laquelle
la résine comprend une résine thermoplastique qui est liquide à une température de 23 °C ;
le matériau de carbone particulaire a un diamètre moyen de 300 μm ou moins et comprend du graphite expansé ; et
la feuille secondaire possède un indice de bouclage de 0,33 ou moins, où l'indice de bouclage est obtenu par, lorsque la feuille secondaire est formée en un carré de 50 mm x 50 mm, un poids de 65 g de 55 mm x 55 mm est placé sur une surface plate de celle-ci pendant 10 secondes, et le poids est ensuite retiré, en divisant une hauteur de bouclage par 50 mm, qui est la longueur d'un côté de la feuille secondaire, où la hauteur de bouclage est mesurée en millimètres depuis la surface plate dans une direction perpendiculaire à la surface plate.

**2.** Feuille secondaire selon la revendication 1, dans laquelle la résine est constituée de la résine thermoplastique qui est liquide à la température de 23 °C.

**3.** Feuille secondaire selon la revendication 1 ou 2, la feuille secondaire ayant une résistance thermique de 0,20 °C/W ou moins sous une pression de 0,05 MPa.

**4.** Feuille secondaire selon l'une quelconque des revendications 1 à 3, dans laquelle un pouvoir adhésif de la feuille secondaire est de 0,80 N ou moins, où le pouvoir adhésif est mesuré comme étant la force nécessaire pour retirer une sonde plate de ϕ 10 mm de la feuille secondaire à mesurer après que la sonde ait été pressée contre la feuille secondaire pendant 10 secondes dans la condition de température de 25 °C tout en appliquant une pression de 0,5 N.

**5.** Feuille secondaire selon l'une quelconque des revendications 1 à 4, où la feuille secondaire a une dureté Asker C à 25 °C de 60 ou plus et 90 ou moins, où la dureté Asker C est mesurée à une température prédéterminée au moyen d'un testeur de dureté selon le procédé Asker C spécifié dans la norme de l'association des fabricants de caoutchouc japonais.

**6.** Procédé de production d'une feuille secondaire comprenant :

le façonnage d'une composition contenant une résine comprenant une résine thermoplastique qui est liquide à une température de 23 °C et un matériau de carbone particulaire ayant un diamètre moyen de 300 μm ou moins et comprenant du graphite expansé ayant une teneur du matériau de carbone particulaire étant de 50 % en masse ou moins en une feuille par application de pression pour produire une feuille primaire ayant une résistance à la traction de 1,5 MPa ou moins, dans lequel la résistance à la traction est mesurée selon JIS K6251 ;

l'obtention d'un stratifié comprenant deux ou plus de deux couches formées par empilement d'une pluralité des feuilles primaires les unes au-dessus des autres ou par pliage ou enroulement de la feuille primaire ; et

le découpage du stratifié à un angle de 45° ou moins par rapport à la direction d'empilement pour obtenir la feuille secondaire, dans lequel la feuille secondaire possède un indice de bouclage de 0,33 ou moins, où l'indice de bouclage est obtenu par, lorsque la feuille secondaire est formée en un carré de 50 mm x 50 mm, un poids de 65 g de 55 mm x 55 mm est placé sur une surface plate de celle-ci pendant 10 secondes, et le poids est ensuite retiré, en divisant une hauteur de bouclage par 50 mm, qui est la longueur d'un côté de la feuille secondaire, où la hauteur de bouclage est mesurée en millimètres depuis la surface plate dans une direction perpendiculaire à la surface plate.

## FIG. 1

*FIG. 2*

*FIG. 3*

*FIG. 4*

*FIG. 5A*

*FIG. 5B*

# FIG. 6A

# FIG. 6B

FIG. 7A

FIG. 7B

# FIG. 8

1

Enlarged

4

5

b

16

d

a

c

## FIG. 9A

## FIG. 9B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011218504 A
- JP 2013131562 A
- WO 2006011655 A1
- WO 2006011655 A